# EUROPEAN PATENT APPLICATION

(11) **EP 4 407 390 A1**
(43) Date of publication of application: **31.07.2024**
(21) Application number: 23153560.0
(22) Date of filing: 26.01.2023
(51) Int. Cl.: G05B 19/05, H03K 19/17736

(54) **ELECTRONIC CIRCUIT**

(71) Applicant: Godde, Gwenaël, Joseph, Marie, 38500 Voiron (FR)
(72) Inventor: Godde, Gwenaël, Joseph, Marie, 38500 Voiron (FR)
(74) Representative: Fidal Innovation

(57) **Abstract**

An electronic circuit comprises:
> An electronic chip (EC) comprising:
o A microprocessor (µP) core,
o A programmable logic core (PLC),
o A plurality of input and output pins,

wherein
> A least one of the input and/or output pins is controlled and/or monitored by the programmable logic core (PLC), in that
> The microprocessor (µP) core is configured to program which input and/or output pin is controlled by the programmable logic core, and in that
> a firmware of the programmable logic core is configured to be programmable by the microprocessor (µP).

## Description

### FIELD OF THE INVENTION

The present invention relates to an electronic circuit comprising an electronic chip.

More specifically, the invention relates to an electronic circuit comprising an electronic chip of microcontroller type - or any electronic chip with General Purpose Input/Output - with a programmable logic core.

### BACKGROUND OF THE INVENTION

In the field of electronic circuit, a first well-known component is a logic programmable circuit, typically a Field Programmable Gate Array (FPGA) or a Complex Programmable Logic Device (CPLD). Such component is a good support to program anything a user wants, for example to simulate a chip and its behaviour. A logic programmable circuit can be reprogramed at any time by the user depending on the wanted functions and applications. However, such component is expensive, fragile and not power efficient.

A second well-known component is an integrated circuit with General Purpose Input/Output and a microprocessor core, typically a microcontroller. Many functions and applications of such component are hardcoded such that they are fixed - or prefixed. More precisely, a user can specify some actions to be done by the circuit by the mean of custom software, but the pins of the chip are each limited to a specific protocol or function. Moreover, the set of protocols and functions available on a microcontroller may differ from another microcontroller. Hence, when a specific type of microcontroller is used for a specific application, it is hard and time-consuming to use another type of microcontroller for the same specific application.

There is then a need to provide an electronic chip that partially answers the above-exposed problems.

### BRIEF SUMMARY OF THE INVENTION

Thus, the invention relates to an electronic circuit comprising:
> An electronic chip comprising:
   ∘ A microprocessor core,
   ∘ A programmable logic core,
   ∘ A plurality of input and output pins,
Characterized in that
➢ A least one of the input and/or output pins is controlled and/or monitored by the programmable logic core, in that
➢ The microprocessor core is configured to program which input and/or output pin is controlled by the programmable logic core, and in that
➢ a firmware of the programmable logic core is configured to be programmable by the microprocessor.

According to different aspects, it is possible to provide the one and / or the other of the characteristics below taken alone or in combination.

In an embodiment, the electronic circuit further comprises a general purpose input/output driver comprising at least one input/output pin, wherein the microprocessor comprises a general purpose input/output mode selector module configured to connect the at least one input/output pin of the general purpose input/output driver to at least one input/output of the electronic chip, said at least one input/output of the electronic chip being configured to be controlled and/or monitored by the programmable logic core.

In an embodiment, the general purpose input/output (GPIO) mode selector module is further configured to disconnect the at least one input/output pin of the general purpose input/output (GPIO) driver to the input/output of the electronic chip (EC) controlled and/or monitored by the programmable logic core (PLC) and to connect said at least one input/output pin of the general purpose input/output (GPIO) driver to at least one input/output of the electronic chip (EC) controlled and/or monitored by the microprocessor (µP) core.

In an embodiment, the electronic circuit further comprises a plurality of general purpose input/output drivers, each being configurable by the general purpose input/output mode selector module to connect at least one input/output pin of the general purpose input/output driver to at least one input/output pin of the electronic chip controlled and/or monitored by the microprocessor core or the programmable logic core.

In an embodiment, the programmable logic core is configured to force a reset or an interrupt of the microprocessor and/or the whole electronic chip if a fault condition is detected by said programmable logic core.

In an embodiment, a first input/output pin of the electronic chip is configured to be connected to a first input/output pin of the general purpose input/output driver, said first input/output pin of the general purpose input/output driver being controlled and/or monitored by the microprocessor core, said microprocessor being configured to send a first order via said first input/output pin of the general purpose input/output driver,
a second input/output pin of the electronic chip is configured to be connected to a second input/output pin of the general purpose input/output driver, said second input/output pin of the general purpose input/output driver being controlled and/or monitored by the microprocessor core, said microprocessor being configured to send a second order via said second input/output pin of the general purpose input/output driver, said second order being different from the first order,
a third input/output pin of the electronic chip is configured to be connected to a third input/output pin of the general purpose input/output driver, outside the electronic chip, said third input/output pin of the general purpose input/output driver being controlled and/or monitored by the programmable logic core, said programmable logic core being configured to receive, via the third input/output pin of the general purpose input/output driver, the first order sent by the microprocessor core,
a fourth input/output pin of the electronic chip is configured to be connected to a fourth input/output pin of the general purpose input/output driver, outside the electronic chip, said fourth input/output pin of the general purpose input/output driver being controlled and/or monitored by the programmable logic core, said programmable logic core being configured to receive, via the fourth input/output pin of the general purpose input/output driver, the second order sent by the microprocessor core,
wherein the programmable logic core is configured to force a reset or an interrupt of the microprocessor core and/or the whole electronic chip controller if the programmable logic core detects a fault condition.

In an embodiment, the microprocessor core is connected to the programmable logic core and configured to send a first and a second orders destined to the general purpose input/output driver by passing said first and second orders to the programmable logic core,
a first input/output pin of the electronic chip is connected to a first input/output pin of the general purpose input/output driver, said first input/output pin of the electronic chip being controlled/monitored by the programmable logic core, the programmable logic core being configured to transmit the first order from the microprocessor core to the general purpose input/output driver via said first input/output pin of the general purpose input/output driver,
a second input/output pin of the electronic chip is connected to a second input/output pin of the general purpose input/output driver, said second input/output pin of the electronic chip being controlled/monitored by the programmable logic core, the programmable logic core being configured to transmit the second order from the microprocessor core to the general purpose input/output driver via said second input/output pin of the general purpose input/output driver,
wherein the programmable logic core is configured to force a reset or an interrupt of the microprocessor core and/or the whole electronic chip if the programmable logic core detects a fault condition, and wherein the programmable logic core is eventually configured to not transmitting said first and second orders to the general purpose input/output driver if a fault detection is detected.

In an embodiment, a first input/output pin of the electronic chip is configured to be connected to a first input/output pin of the general purpose input/output driver, said first input/output pin of the general purpose input/output driver being controlled and/or monitored by the microprocessor core, said microprocessor being configured to send a first order via said first input/output pin of the general purpose input/output driver,
a second input/output pin of the electronic chip is configured to be connected to a second input/output pin of the general purpose input/output driver, said second input/output pin of the general purpose input/output driver being controlled and/or monitored by the microprocessor core, said microprocessor being configured to send a second order, said second order being different from said first order, via said second input/output pin of the general purpose input/output driver,
the programmable logic core is configured to monitor first and second input/output pins of the general purpose input/output driver from inside the electronic chip, wherein said programmable logic core is configured to force a reset or an interrupt of the microprocessor core and/or the whole electronic chip if a fault condition is detected.

In an embodiment, the fault condition is related to the orders sent by the microprocessor and/or to a state of the pin(s) of the general purpose input/output driver.

In an embodiment, the electronic chip further comprises an internal memory bus, an internal memory and internal registers, wherein the internal memory bus is configured to connect the programmable logic core, the internal memory and the internal registers together.

In an embodiment, the programmable logic core is configured to be programmed to create an interface with an external device, said external device being external from the electronic chip, said interface allowing said external device to access, read and/or write predefined locations in the internal memory and/or internal registers via the internal memory bus.

In an embodiment, the programmable logic core is further configured to program an interface with an external device, said interface allowing the microprocessor core to read and/or write in predefined locations of an internal memory and/or internal registers of said external device via an internal bus of said external device.

In an embodiment, the programmable logic core is further configured to be programmed to, upon a request from the microprocessor core to access a location of the internal memory or internal registers, modify said memory location so the microprocessor effectively accesses the modified memory location.

### BRIEF DESCRIPTION OF THE DRAWINGS

Embodiments of the invention will be described below with reference to the drawings, described briefly below:
[Fig. 1] represents a schematical overview of an electronic chip according to an embodiment of the present application.
[Fig. 2] represents an example of a connection of the programmable logic core to a General Purpose Input/Output GPIO driver.
[Fig. 3] illustrates a function of monitoring external signals of the electronic chip according to an embodiment.
[Fig. 4] illustrates a function of monitoring external signals of the electronic chip according to another embodiment.
[Fig. 5] illustrates a function of monitoring external signals of the electronic chip according to another embodiment.
[Fig. 6] is a general overview of some connexions that can be performed in the electronic chip according to an embodiment.
[Fig. 7] illustrates an example of communication between some components of the electronic chip and an external device.
[Fig. 8] illustrates an exemplative configuration in which the programmable logic core can be used to custom data processing.
[Fig. 9] illustrates another exemplative configuration in which the programmable logic core can be used to customize access of a second microprocessor core to other components of the electronic circuit.
[Fig. 10] illustrates a comparison of latency response between the programmable logic core and the microprocessor core in an exemplative embodiment.

In the drawings, identical references designate identical or similar objects.

### DETAILED DESCRIPTION OF THE INVENTION

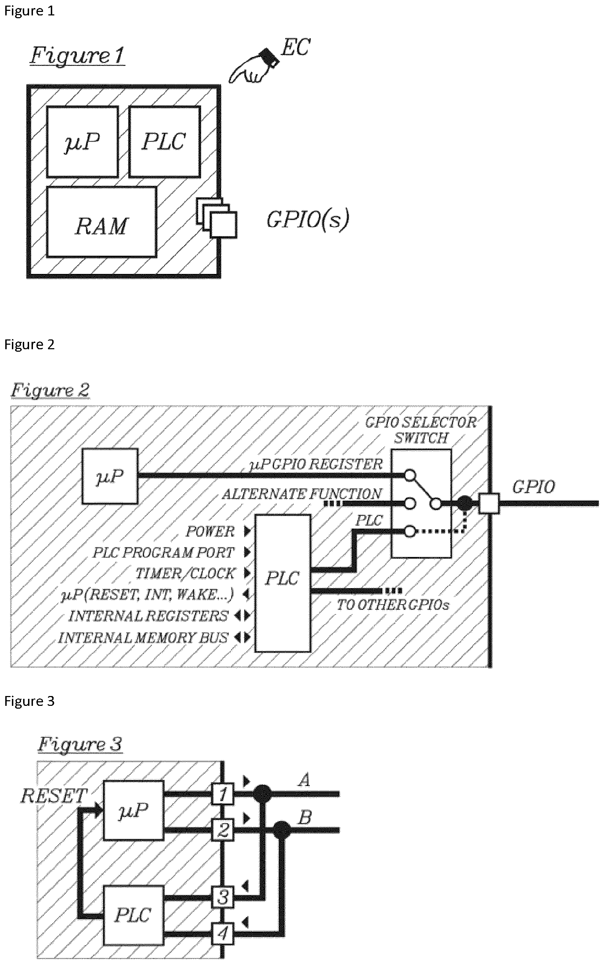

Figure 1 schematically shows an overview of an electronic chip EC according to an embodiment of the present application.

The electronic chip EC (or chip EC) of microcontroller MCU type (or any electronic chip with a General Purpose Input/Output GPIO) comprises a microprocessor µP core and a programmable logic core PLC.

The microprocessor µP may be of any type. As a non-limitative example, the microprocessor µP may be of ARM type.

The programmable logic core PLC may be a Field-programmable gate array (FPGA) or a complex programmable logic device (CPLD) type, or any other programmable logic type.

The electronic chip EC may also comprise at least one internal memory and internal configuration registers. The electronic chip EC may also comprise Direct Memory Access DMA channels, at least one timer and at least a clock.

The electronic chip EC also comprises an internal memory bus IMB. The internal memory bus IMB may be connected with the microprocessor µP core, the programmable logic core PLC, the internal memory and/or the internal registers REG.

The electronic chip EC may also comprise a program port connecting the programmable logic core PLC and the microprocessor µP core such that the programmable logic core PLC can be programmed and/or reprogrammed by the microprocessor µP core with respect to the functionalities needed. In an embodiment, a specific programming port of the programmable logic core PLC is used by the microprocessor core to program/reprogram the programmable logic core PLC.

The electronic chip EC may be part of an electronic circuit comprising at least one General Purpose Input/Output GPIO driver, to which the programmable logic core PLC may be tied. More specifically, a "PLC mode" may be added to the microcontroller's General Purpose Input/Output selector switch. Such switch allows to connect the GPIO driver to a pin having specific functionality.

When the PLC mode is selected, the General Purpose Input/Output GPIO driver is controlled by the programmable logic core. The program logic core may then control the output state, the input/output switch, the pull up switch, the pull down switch and/or the bus-hold switch.

The programmable logic core PLC may then have access to the microprocessor µP core. More precisely, the programmable logic core PLC may have access to the microprocessor µP core's interrupts, wake and/or reset functions.

The programmable logic core PLC may also have access to the DMA channels, the timer and/or the clock.

The programmable logic core PLC may also have access to the internal memory bus IMB by the mean of bus request.

Furthermore, since the programmable logic core can be connected to the internal memory bus IMB, the microprocessor µP can read or write data into the programmable logic core PLC may some memory registers implemented into the programmable logic core PLC logic. This allows for the microprocessor µP to change some internal settings of the programmable logic core PLC on the fly.

The electronic chip may also comprise a power switch to which the programmable logic core PLC can be shut down partially or entirely to save power.

At least one of the above-mentioned features (or a combination of one of these features) allows the electronic chip EC to interface with devices and protocols not usually compatible with the electronic chip EC since the programmable logic core PLC can be programmed to run with such protocols or devices.

It also allows for the electronic chip EC to interface with device or protocol yet to be invented since the programmable logic core PLC can be programmed to run with such protocols or devices.

It may also allow for external device EDs to access the internal memory of the chip since the programmable logic core PLC can be programmed to authorize such access.

It may also allow to monitor external signals and serve as a barrier for extra
security and protection. More precisely, the programmable logic core PLC may function as an advanced watchdog allowing for fault detection of software error and/or hardware failure.

The programmable logic core PLC programming port access may be locked by the microprocessor µP after the initial programmable logic core PLC programming is completed. This ensures no tempering with the fault detection logic - eventually implemented inside the programmable logic core as explained in more details below. The programmable logic core PLC programming port may be locked until the next microprocessor and/or electronic chip reset.

Generally, in the figures, the small squares illustrate a physical pin of the electronic chip EC connected to a General Purpose I/O GPIO driver. The black dots illustrate a connection - being physical outside the electronic chip EC or, for monitoring purpose, inside the electronic chip EC. The dashed area on the left represents the internal of the electronic chip EC and the un-dashed area on the right is the outside of the electronic chip EC.

Figure 2 illustrates the connection of the programmable logic core PLC to the General Purpose Input/Output GPIO driver.

The programmable logic core PLC is connected to the General Purpose Input/Output GPIO driver via the General Purpose Input/Output mode selector switch. When selected, the programmable logic core PLC can override pin direction and output value settings of the attached General Purpose Input/Output GPIO driver. Moreover, the programmable logic core PLC can read the General Purpose Input/Output GPIO input or output value at any time, no matter the General Purpose Input/Output mode selector switch position, allowing for transparent monitoring, thanks to the connexion illustrated in dotted line on figure 2.

Figures 3 to 5 illustrate the function of monitoring external signals of the electronic chip EC according to three embodiments.

The embodiments of figures 3 to 5 are not mutually exclusive, such that the embodiments of figures 3 to 5 can be implemented on the same chip, at the same time, using different pins as it will be comprehensible with the description below.

Moreover, since several General Purpose Input/Output GPIO drivers may be used, the General Purpose Input/Output GPIO driver connections to the electronic chip may be implemented according to figures 3, 4 and/or 5.

In the non-limitative examples, A and B correspond to orders sent from the electronic chip via the General Purpose Input/Output GPIO driver. The A and B orders are different from each other. As non-limitative examples, they can correspond to "open door" and "close door" orders, or to "light" or "switch off" orders.

It is understood that these are just examples, and any type of orders enter within the scope of the present application. Furthermore, the numbers of orders sent is not restricted to two order A and B but can include a plurality of different orders.

Several fault conditions can be detected. All fault detections may be implemented to be detected at the same time for a same General Purpose Input/Output GPIO driver, or for all General Purpose Input/Output GPIO drivers. Some fault detections may be implemented for one General Purpose Input/Output GPIO driver only, while other fault detections may be implemented for others General Purpose Input/Output GPIO drivers.

As an example, a fault condition may be detected if there is a timing violation such as (but not limited to) : orders sent at the same time, violation of a timing delay between the sending of two orders, a time interval during which an order must not be sent and/or must be sent, a time interval during which a pin of the General Purpose Input/Output GPIO driver must stay at the same state.

Hence, the fault condition may be detected by the programmable logic core PLC regarding the orders sent by the microprocessor µP and/or the states of the pins of the General Purpose Input/Output GPIO driver.

The fault condition may also/in alternative comprise the computations of multiple General Purpose Input/Output GPIO drivers, internal register or internal memory values, a comparison with previous states, sequence detections, external signal not related to the microprocessor µP detection, internal temperature, analog to digital conversion, checksum, power loss and/or the order must be send together with a predefined key.

In the first embodiment of figure 3, a first pin of the electronic chip EC is connected to a first pin of the General Purpose Input/Output GPIO driver and controller by the microprocessor µP. The first pin of the electronic chip EC is programmed to send the A order.

A second pin of the electronic chip EC is connected to a second pin of the General Purpose Input/Output GPIO driver and controlled by the microprocessor µP. The second pin of the electronic chip EC is programmed to send the B order.

A third pin of the electronic chip EC is connected to a third pin of the General Purpose Input/Output GPIO driver and controlled and/or monitored by the programmable logic core PLC.

A fourth pin of the electronic chip EC is connected to a fourth pin of the General Purpose Input/Output GPIO driver and controlled and/or monitored by the programmable logic core PLC.

In this embodiment, the third pin of the electronic chip EC is physically connected to the first pin of the General Purpose Input/Output GPIO driver, outside the electronic chip, for example by mean of a wire. The fourth pin of the electronic chip EC may also be physically connected to the second pin of the General Purpose Input/Output GPIO driver, outside the electronic chip, for example by mean of a wire.

The programmable logic core PLC can monitor the orders sent by the microprocessor µP. More precisely, it receives the state of the first and second pins of the General Purpose Input/Output GPIO driver.

For example, if the microprocessor µP sends the order A, the state of the first pin of the General Purpose Input/Output GPIO driver will be 1, otherwise it is 0. Also, if the microcontroller MCU send the order B, the state of the second pin of the General Purpose Input/Output GPIO driver will be 1, otherwise it is 0.

If the programmable logic core PLC detects that there is a fault condition, the programmable logic core PLC is configured to reset or interrupt the microprocessor µP and/or the whole electronic chip EC.

This embodiment is particularly advantageous since the fault can be detected outside the electronic chip EC, as four pins of the electronic chip are used for the monitoring. The microprocessor µP and/or the whole electronic chip EC would be forced to reset if one of the input/output is not working, externally shorted and/or disconnected.

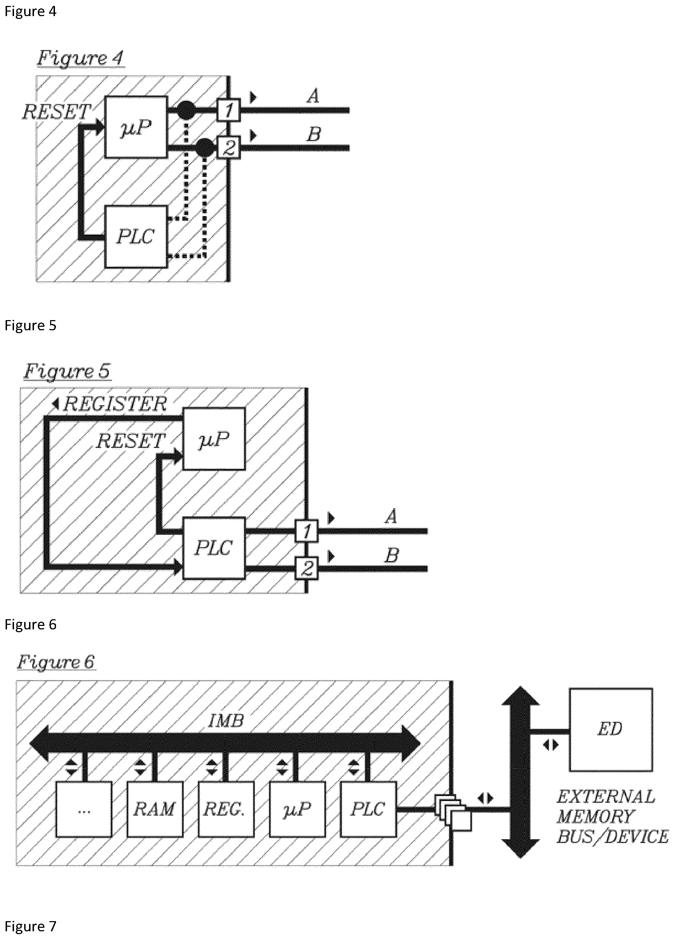

On figure 4, a first pin of the electronic chip EC is connected to a first pin of the General Purpose Input/Output GPIO driver and controlled by the microprocessor µP. The first pin of the microprocessor µP is programmed to send the A order.

A second pin of the electronic chip is connected to a second pin of the General Purpose Input/Output GPIO driver and controlled by the microprocessor µP. The second pin of the electronic chip EC is programmed to send the B order.

Inside the chip is the programable logic core PLC monitoring the first and second pins of the General Purpose Input/Output GPIO driver.

The programmable logic core PLC monitors the orders sent by the microprocessor µP. More precisely, it receives the state of the first and second pins of the General Purpose Input/Output GPIO driver. The state of the first and second pins of the General Purpose Input/Output GPIO driver is modified according to the order sent by the microprocessor µP.

For example, if the microprocessor µP sends the order A, the state of the first pin of the General Purpose Input/Output GPIO driver will be 1, otherwise it is 0. Also, if the microprocessor µP sends the order B, the state of the second pin of the General Purpose Input/Output GPIO driver will be 1, otherwise it is 0.

In this embodiment, if the programmable logic core PLC detects that there is a fault condition, the programmable logic core PLC is configured to reset or interrupt the microprocessor µP and/or the whole electronic chip EC.

This embodiment is advantageous since it only uses two pins of the electronic chip EC. Furthermore, the logic added to the programable logic core PLC to have access to the states of first and second pins of the GPIO driver allows the programable core logic PLC to access the General Purpose Input/Output GPIO driver output values at any time, even if the General Purpose Input/Output driver is set to the General Purpose Input/Output GPIO mode and not the programmable logic core mode (see figure 2).

On figure 5, a first pin of the electronic chip EC is connected to the first pin of the General Purpose Input/Output GPIO driver and controlled by the programmable logic core PLC. The programmable logic core PLC receives a first order from the microprocessor µP and passes it to the General Purpose Input/Output GPIO driver via its first pin.

A second pin of the electronic chip EC is connected to a second pin of the General Purpose Input/Output GPIO driver and controlled by the programmable logic core PLC. The programmable logic core PLC receives a second order from the microprocessor µP and passes it to the General Purpose Input/Output GPIO driver via its second pin.

In this embodiment, if the programmable logic core PLC detect that there is a fault condition, the programmable logic core PLC is configured to force the microprocessor µP to reset or interrupt. In this configuration, the programmable logic core PLC can be configured to reset or interrupt the microprocessor µP without transmitting said first and second orders to the General Purpose Input/Output GPIO driver if the first and second orders are sent at the same time.

This configuration is advantageous since only two pins of the electronic chip EC are used. Furthermore, the security will be ensured at any time.

In the embodiments of figures 3 to 5, the electronic chip is configured such that even if the microprocessor µP disconnects from the programmable logic core to perform other functionalities, i.e. the programmable logic core PLC cannot modify a state of an output, the programmable logic core PLC can still read/monitor the output and reset or interrupt the microprocessor µP and/or reset or interrupt the whole electronic chip EC if needed.

Figures 6 to 10 illustrate the function of interfacing the electronic chip EC with other devices/protocols and/or to devices/protocol yet to be invented.

Figure 6 is a general overview of some connexions that can be performed in the electronic chip EC, according to a non limitative embodiment.

As can be seen, the electronic chip EC comprises an internal memory bus IMB. The internal memory bus IMB may be connected to the programmable logic core PLC, the internal register(s), the internal memory and the microprocessor µP core.

The programmable logic core PLC may be physically connected to (at least) one external bus or external memory. The external bus or external memory are a bus or a memory of an external device ED, i.e. distinct from the electronic chip EC.

More precisely, the pins of the programmable logic core PLC, represented by a plain square, may be connected to the address bus and/or data bus of the external bus or memory.

The programmable logic core PLC can be programmed to create an interface allowing the external device ED to communicate with the electronic chip EC.

More precisely, the interface may be put on the internal memory bus IMB of the electronic chip EC, such that the external device ED may be allowed to read and write inside the electronic chip EC, i.e.in the internal register(s) and/or the internal memory.

To do so, the programmable logic of the programmable logic core PLC may comprise a logic gate indicating that some locations of the internal memory bus IMB IMB are free to be read/written from an external device ED. These locations may change at any time by reprogramming the logic of the programmable logic core.

The external device ED may be an existing device, or a device to be created at the date of this patent application. Indeed, the programable logic core PLC is reprogrammable by the microprocessor µP at any time.

The programmable logic of the programmable logic core PLC may also comprise logic gates indicating that some locations of the internal memory bus IMB cannot be accessed by an external device ED. It allows to ensure the security and integrity of the electronic chip. These locations may change at anytime by reprogramming the logic of the programmable logic core.

Also, the programable logic of the programmable logic core PLC can be programmed such that the microprocessor µP can access locations of the external device ED, such as locations of the external memory and/or external bus.

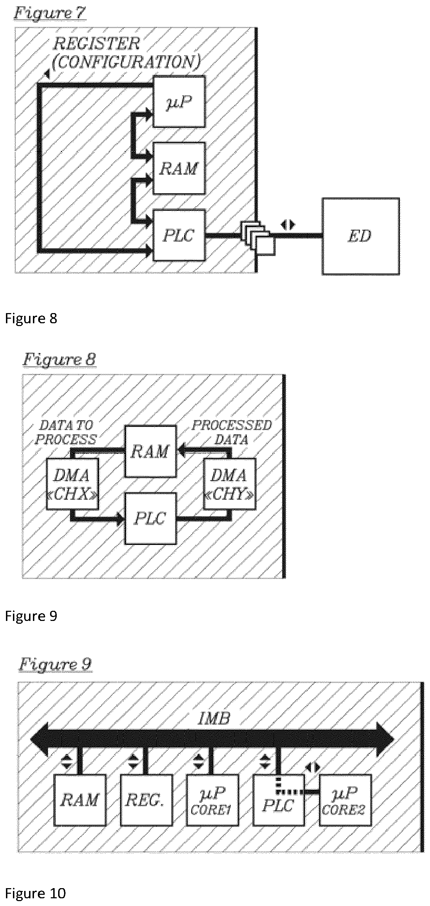

Figure 7 more precisely illustrates an example of communication between some components of the electronic chip and an external device ED.

As can be seen, the external device ED is connected to at least one pin of the electronic chip, controlled and/or monitored by the programable logic core PLC.

The microprocessor µP has programmed the programmable logic core PLC so the internal RAM is used as a communication buffer between the external device ED and the microprocessor µP. Both the microprocessor µP and the programmable logic core PLC can read/write in the internal memory RAM.

Figure 8 illustrates another configuration in which the programmable logic core PLC can be used to custom data processing such as - but not limited to - bit manipulation, operation, compression, decompression, encryption, decryption, encoding, decoding and/or checksum...

The programmable logic core PLC can be used as an internal memory interface to process data inside the electronic chip EC.

In this example, the microprocessor µP programs the programmable logic core PLC to process data sent from the internal memory RAM of the chip EC through the direct memory access DMA channel CHX. The processed data is then sent back to the internal memory RAM through another direct memory access channel CHY.

In this example, the direct memory access DMA logic is located outside of the programmable logic core PLC and configured by the microprocessor µP separately so they can point from/to any address inside of the internal memory RAM without having to reconfigure the programmable logic core PLC. This is advantageous because direct access memory DMA channel is more complex to implement inside the programmable logic core PLC and therefore using generic microprocessor direct memory access DMA channel saves logic resources inside the programmable logic core PLC, resulting in lower power consumption.

Figure 9 illustrates another embodiment.

On figure 9, the electronic chip EC comprises respectively a first and a second microprocessor cores µP core 1, µP core 2.

The first core and the programable logic core PLC are connected via the internal memory bus IMB.

The second core is directly connected to the programmable logic core PLC such that the second core has no choice but to pass through the programmable logic core PLC to access the internal bus. Thus, when the second core wants to access a specific location, the programmable logic core PLC can modify, allow and/or forbid the wanted location so the second core effectively accesses the location given by the programmable logic core PLC. Illegal access can also be monitored for increased security and/or software fault detection.

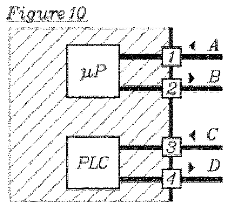

On figure 10, a first pin of the electronic chip EC, controlled and/or monitored by the microprocessor µP, is connected to a first pin of the General Purpose Input/Output GPIO driver, and a second pin of the electronic chip EC, controlled and/or monitored by the microprocessor µP, is connected to a second pin of the General Purpose Input/Output.

The first pin of the electronic chip EC receives a data A via the first pin of the General Purpose Input/Output. The microprocessor µP core is then configured to process data A, for example by performing a calculation on data A, and send data B which is a result of the processing of data A.

In this configuration, the latency response between the A input and B output roundtrip may be consequent, i.e. several tens of nanoseconds if the microprocessor µP is completely dedicated to this task, or hundreds of nanoseconds if the microprocessor µP uses interrupts. Indeed, the microprocessor µP may constantly monitor the value of data A to reflect a change on data B if needed.

Still on figure 10, a third pin of the electronic chip EC, controlled and/or monitored by the programmable logic core PLS, is connected to a third pin of the General Purpose Input/Output GPIO driver, and a fourth pin of the electronic chip EC, controlled and/or monitored by the programmable logic core PLC, is connected to a fourth pin of the General Purpose Input/Output.

The third pin of the electronic chip EC receives a data C via the third pin of the General Purpose Input/Output. The programmable logic core PLC is then configured to process data C, for example by performing a calculation on data C, and send data D which is a result of the processing of data D.

In this configuration, the latency response in very low, compared to the latency response of the embodiment in which the microprocessor µP is processing data A, since the processing is purely logical. This configuration is then particularly advantageous for applications requiring a low latency response.

While exemplary embodiment of the invention has been described with reference to two main embodiments, it will be understood by those skilled in the art that various changes, omissions and/or additions may be made, and equivalents may be substituted for elements thereof without departing from the spirit and scope of the invention. In addition, many modifications may be made to adapt a particular situation or material to the teachings of the invention without departing from the scope thereof. Therefore, it is intended that the invention is not limited to the particular embodiment disclosed as the best mode contemplated for carrying out this invention, but that the invention will include all embodiments falling within the scope of the appended claims. Moreover, unless specifically stated any use of the terms first, second, etc. do not denote any order or importance, but rather the terms first, second, etc. are used to distinguish one element from another.

## Claims

1. Electronic circuit comprising:
➢ An electronic chip comprising:
∘ A microprocessor (µP) core,
∘ A programmable logic core (PLC),
∘ A plurality of input and output pins,
**Characterized in that**
➢ A least one of the input and/or output pins is controlled and/or monitored by the programmable logic core (PLC), **in that**
➢ The microprocessor (µP) core is configured to program which input and/or output pin is controlled by the programmable logic core, and **in that**
➢ a firmware of the programmable logic core is configured to be programmable by the microprocessor (µP).

2. Electronic circuit according to claim 1, further comprising a general purpose input/output (GPIO) driver comprising at least one input/output pin, wherein the microprocessor (µP) comprises a general purpose input/output (GPIO) mode selector module configured to connect the at least one input/output pin of the general purpose input/output (GPIO) driver to at least one input/output of the electronic chip (EC), said at least one input/output of the electronic chip (EC) being configured to be controlled and/or monitored by the programmable logic core (PLC).

3. Electronic circuit according to claim 1 or 2, wherein the general purpose input/output (GPIO) mode selector module is further configured to disconnect the at least one input/output pin of the general purpose input/output (GPIO) driver to the input/output of the electronic chip (EC) controlled and/or monitored by the programmable logic core (PLC) and to connect said at least one input/output pin of the general purpose input/output (GPIO) driver to at least one input/output of the electronic chip (EC) controlled and/or monitored by the microprocessor (µP) core.

4. Electronic circuit according to one of claims 2 or 3, further comprising a plurality of general purpose input/output (GPIO) drivers, each being configurable by the general purpose input/output (GPIO) mode selector module to connect at least one input/output pin of the general purpose input/output (GPIO) driver to at least one input/output pin of the electronic chip (EC) controlled and/or monitored by the microprocessor core or the programmable logic core (PLC).

5. Electronic circuit according to any of the preceding claims, wherein the programmable logic core (PLC) is configured to force a reset or an interrupt of the microprocessor (µP) and/or the whole electronic chip (EC) if a fault condition is detected by said programmable logic core (PLC).

6. Electronic circuit according to the preceding claim, wherein
➢ a first input/output pin of the electronic chip (EC) is configured to be connected to a first input/output pin of the general purpose input/output (GPIO) driver, said first input/output pin of the general purpose input/output (GPIO) driver being controlled and/or monitored by the microprocessor (µP) core, said microprocessor (µP) being configured to send a first order via said first input/output pin of the general purpose input/output (GPIO) driver,
➢ a second input/output pin of the electronic chip (EC) is configured to be connected to a second input/output pin of the general purpose input/output (GPIO) driver, said second input/output pin of the general purpose input/output (GPIO) driver being controlled and/or monitored by the microprocessor (µP) core, said microprocessor (µP) being configured to send a second order via said second input/output pin of the general purpose input/output (GPIO) driver, said second order being different from the first order,
➢ a third input/output pin of the electronic chip (EC) is configured to be connected to a third input/output pin of the general purpose input/output (GPIO) driver, outside the electronic chip (EC), said third input/output pin of the general purpose input/output (GPIO) driver being controlled and/or monitored by the programmable logic core (PLC), said programmable logic core (PLC) being configured to receive, via the third input/output pin of the general purpose input/output (GPIO) driver, the first order sent by the microprocessor core,
➢ a fourth input/output pin of the electronic chip (EC) is configured to be connected to a fourth input/output pin of the general purpose input/output (GPIO) driver, outside the electronic chip (EC), said fourth input/output pin of the general purpose input/output (GPIO) driver being controlled and/or monitored by the programmable logic core (PLC), said programmable logic core (PLC) being configured to receive, via the fourth input/output pin of the general purpose input/output (GPIO) driver, the second order sent by the microprocessor core,
➢ wherein the programmable logic core (PLC) is configured to force a reset or an interrupt of the microprocessor (µP) core and/or the whole electronic chip (EC) controller if the programmable logic core (PLC) detects a fault condition.

7. Electronic circuit according to any of preceding claims, wherein:
➢ the microprocessor (µP) core is connected to the programmable logic core (PLC) and configured to send a first and a second orders destined to the general purpose input/output (GPIO) driver by passing said first and second orders to the programmable logic core (PLC),
➢ a first input/output pin of the electronic chip is connected to a first input/output pin of the general purpose input/output (GPIO) driver, said first input/output pin of the electronic chip (EC) being controlled/monitored by the programmable logic core (PLC), the programmable logic core (PLC) being configured to transmit the first order from the microprocessor core (µP) to the general purpose input/output (GPIO) driver via said first input/output pin of the general purpose input/output (GPIO) driver,
➢ a second input/output pin of the electronic chip is connected to a second input/output pin of the general purpose input/output (GPIO) driver, said second input/output pin of the electronic chip (EC) being controlled/monitored by the programmable logic core (PLC), the programmable logic core (PLC) being configured to transmit the second order from the microprocessor core (µP) to the general purpose input/output (GPIO) driver via said second input/output pin of the general purpose input/output (GPIO) driver,
➢ wherein the programmable logic core (PLC) is configured to force a reset or an interrupt of the microprocessor (µP) core and/or the whole electronic chip (EC) if the programmable logic core (PLC) detects a fault condition, and wherein the programmable logic core is eventually configured to not transmitting said first and second orders to the general purpose input/output (GPIO) driver if a fault detection is detected.

8. Electronic circuit according to any of the preceding claims, wherein:
➢ a first input/output pin of the electronic chip (EC) is configured to be connected to a first input/output pin of the general purpose input/output (GPIO) driver, said first input/output pin of the general purpose input/output (GPIO) driver being controlled and/or monitored by the microprocessor (µP) core, said microprocessor (µP) being configured to send a first order via said first input/output pin of the general purpose input/output (GPIO) driver,
➢ a second input/output pin of the electronic chip (EC) is configured to be connected to a second input/output pin of the general purpose input/output (GPIO) driver, said second input/output pin of the general purpose input/output (GPIO) driver being controlled and/or monitored by the microprocessor (µP) core, said microprocessor (µP) being configured to send a second order, said second order being different from said first order, via said second input/output pin of the general purpose input/output (GPIO) driver,
➢ the programmable logic core (PLC) is configured to monitor first and second input/output pins of the general purpose input/output (GPIO) driver from inside the electronic chip (EC), wherein said programmable logic core is configured to force a reset or an interrupt of the microprocessor (µP) core and/or the whole electronic chip (EC) if a fault condition is detected.

9. Electronic circuit according to, **characterized in that** the fault condition is related to the orders sent by the microprocessor and/or to a state of the pin(s) of the general purpose input/output (GPIO) driver.

10. Electronic circuit according to any of preceding claims, wherein the electronic chip (EC) further comprises an internal memory bus (IMB), an internal memory (RAM) and internal registers (REG), wherein the internal memory bus (IMB) is configured to connect the programmable logic core (PLC), the internal memory (RAM) and the internal registers (REG) together.

11. Electronic circuit according to the preceding claim, wherein the programmable logic core (PLC) is configured to create an interface with an external device (ED), said external device (ED) being external from the electronic chip (EC), said interface allowing said external device (ED) to access, read and/or write predefined locations in the internal memory (RAM) and/or internal registers (REG) via the internal memory bus (IMB).

12. Electronic circuit according to the preceding claim, wherein the programmable logic core (PLC) is further configured to program an interface with an external device (ED), said interface allowing the microprocessor (µP) core to read and/or write in predefined locations of an internal memory and/or internal registers of said external device (ED) via an internal bus of said external device (ED).

13. Electronic circuit according to any of the preceding claims, wherein the programmable logic core (PLC) is further configured to be programmed to, upon a request from the microprocessor core (µP) to access a location of the internal memory (RAM) or internal registers (REG), modify said memory location so the microprocessor (µP) effectively accesses the modified memory location.
